# EUROPEAN PATENT APPLICATION

(11) **EP 4 848 621 A1**
(43) Date of publication of application: **02.12.2026**
(21) Application number: 24920073.4
(22) Date of filing: 24.12.2024
(51) Int. Cl.: H04B 17/318, G01R 23/165, G01R 23/167

(54) **POWER SPECTRUM DETECTOR, RECEIVING SYSTEM, AND RECEIVING STATION**

(30) Priority: 25.01.2024 JP 2024009378
(71) Applicant: Mitsubishi Electric Corporation, Tokyo 100-8310 (JP)
(72) Inventor: FUJIMURA, Akinori, Tokyo 100-8310 (JP)
(74) Representative: Hoffmann Eitle
(86) International application number: PCT/JP2024/045584
(87) International publication number: WO 2025/158850

(57) **Abstract**

A digital filter bank (220) decomposes a baseband signal obtained from a received signal into a plurality of subbands and outputs a plurality of pieces of complex subband data. A power converter (208) calculates, for each subband of the plurality of subbands, received power of the received signal in the subband based on the complex subband data for the subband and outputs received power spectrum data. The plurality of subbands are arranged consecutively in a frequency direction at a frequency spacing ΔF. The digital filter bank (220) has a frequency characteristic where a single-sided occupied bandwidth of each subband of the plurality of subbands is equal to or smaller than the frequency spacing ΔF and a power sum of frequency-to-power characteristics of two subbands adjacent in the frequency direction among the plurality of subbands is constant.

## Description

### Technical Field

The present disclosure relates to detection of a power spectrum of a received signal.

### Background Art

A method using a digital filter bank is known as a means for detecting a power spectrum of a received signal.

Patent Literature 1 and Patent Literature 2 describe FFT (discrete Fourier transform) as a specific method for realizing the digital filter bank.

When detecting the power spectrum of a received signal using the FFT described in Patent Literature 1 and Patent Literature 2, the detection characteristics of the power spectrum depend on a window function used to extract a time waveform during the FFT.

Digital filter banks (digital decomposition, digital synthesis) are known as channelizers for relaying signals.

Patent Literature 3 describes a tree circuit composed of a plurality of half band filters (HBFs) and a plurality of channel filters (CFs) as a specific method for realizing the digital filter bank.

When detecting the power spectrum of a received signal using the tree circuit described in Patent Literature 3, the band of the own subband is primarily extracted, while other bands are suppressed to several tens of decibels, resulting in a steep frequency characteristic. Therefore, problems associated with employing the FFT do not arise.

However, if no constraints are applied to the frequency characteristic of the subband, detection errors occur when detecting the power spectrum of the received signal.

### Citation List

### Patent Literature

Patent Literature 1: JP 4084269
Patent Literature 2: JP 4812685
Patent Literature 3: JP 5575149

### Summary of Invention

### Technical Problem

The present disclosure aims to accurately detect a power spectrum of a received signal.

### Solution to Problem

A power spectrum detector according to the present disclosure includes:
a digital filter bank to decompose a baseband signal obtained from a received signal into a plurality of subbands and to output a plurality of pieces of complex subband data; and
a power converter to calculate, for each subband of the plurality of subbands, received power of the received signal in the subband based on said complex subband data for the subband and to output received power spectrum data, wherein
the plurality of subbands are arranged consecutively in a frequency direction at a frequency spacing ΔF, and
the digital filter bank has a frequency characteristic where a single-sided occupied bandwidth of each subband of the plurality of subbands is equal to or smaller than the frequency spacing ΔF and a power sum of frequency-to-power characteristics of two subbands adjacent in the frequency direction among the plurality of subbands is constant.

### Advantageous Effects of Invention

According to the present disclosure, a power spectrum of a received signal can be accurately detected.

### Brief Description of Drawings

Fig. 1 is a configuration drawing of a receiving system 100 according to Embodiment 1.
Fig. 2 is a configuration drawing of a terminal station 200 according to Embodiment 1.
Fig. 3 is a configuration drawing of a ground station 300 according to Embodiment 1.
Fig. 4 is a configuration drawing of a digital filter bank 220 according to Embodiment 1.
Fig. 5 is a drawing illustrating a frequency-to-power characteristic of the digital filter bank 220 according to Embodiment 1.
Fig. 6 is a drawing illustrating a frequency-to-amplitude characteristic of the digital filter bank 220 according to Embodiment 1.
Fig. 7 is a drawing illustrating a frequency characteristic of the digital filter bank 220 according to Embodiment 1.
Fig. 8 is a drawing illustrating an example of the frequency characteristic of the digital filter bank 220 according to Embodiment 1.
Fig. 9 is a drawing illustrating a frequency-to-amplitude characteristic after passing through a receiving filter 303 according to Embodiment 1.
Fig. 10 is a drawing illustrating an image of decomposition processing by the digital filter bank 220 according to Embodiment 1.
Fig. 11 is a drawing illustrating an image of synthesis processing by a synthesis filter 304 according to Embodiment 1.
Fig. 12 is a drawing illustrating an example of a conventional normalized-frequency-to-power characteristic.
Fig. 13 is a drawing illustrating an example of a conventional frequency-to-amplitude characteristic.
Fig. 14 is a configuration drawing of a receiving station 101 according to Embodiment 2.
Fig. 15 is a drawing illustrating an example of a frequency-to-power characteristic of the digital filter bank 220 according to Embodiment 3.
Fig. 16 is a drawing illustrating an example of a frequency characteristic of the digital filter bank 220 according to Embodiment 3.
Fig. 17 is a drawing illustrating an example of a lookup table according to Embodiment 3.
Fig. 18 is a drawing illustrating an example of a moving average of a band-limited signal according to Embodiment 3.
Fig. 19 is a drawing illustrating an example of center frequency estimation according to Embodiment 3.

### Description of Embodiments

In embodiments and drawings, the same or corresponding components are given the same reference characters. Description of a component having the same reference character as that of a described component will be omitted or simplified as appropriate. Arrows in the drawings primarily indicate a flow of signals or a flow of a process.

### Embodiment 1.

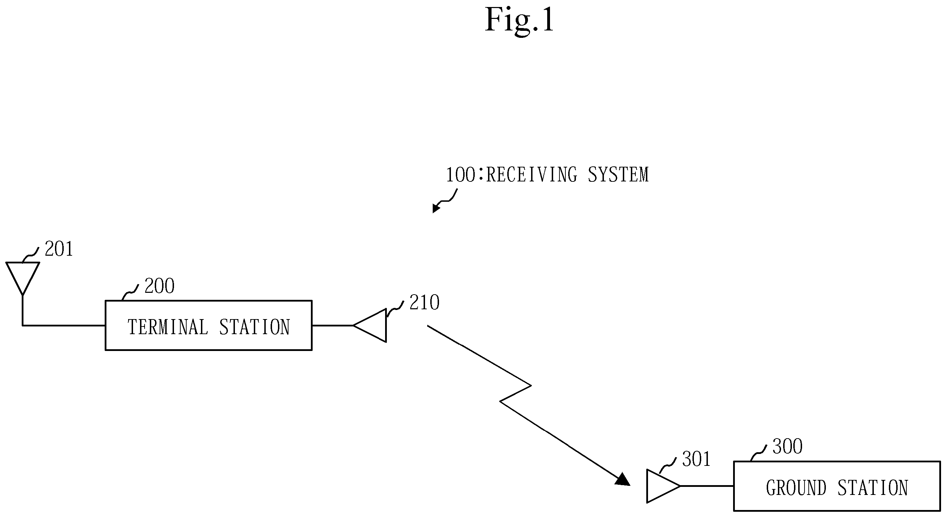

A receiving system 100 will be described with reference to Fig. 1 to Fig. 14.

### ***Description of configuration***

A configuration of the receiving system 100 will be described with reference to Fig. 1.

The receiving system 100 includes a terminal station 200 and a ground station 300.

The terminal station 200 and the ground station 300 communicate wirelessly.

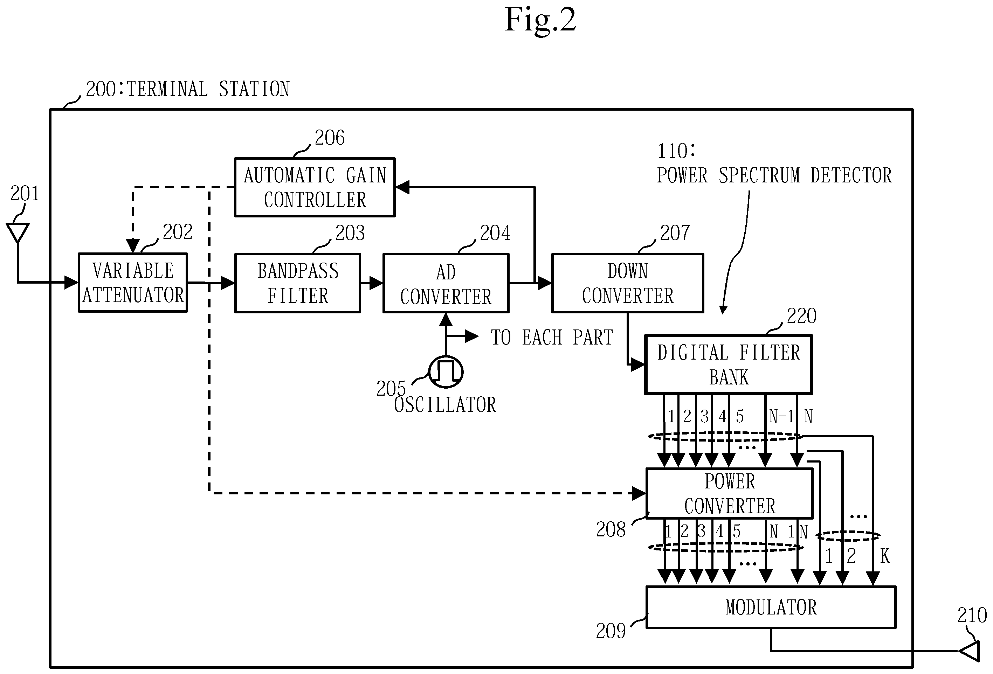

A configuration of the terminal station 200 will be described with reference to Fig. 2.

The terminal station 200 includes a receiving antenna 201, a variable attenuator 202, a bandpass filter 203, an AD converter 204, an oscillator 205, an automatic gain controller 206, and a downconverter 207.

The terminal station 200 further includes a digital filter bank 220, a power converter 208, a modulator 209, and a transmitting antenna 210.

The terminal station 200 includes a power spectrum detector 110.

The power spectrum detector 110 is a circuit which includes the digital filter bank 220 and the power converter 208.

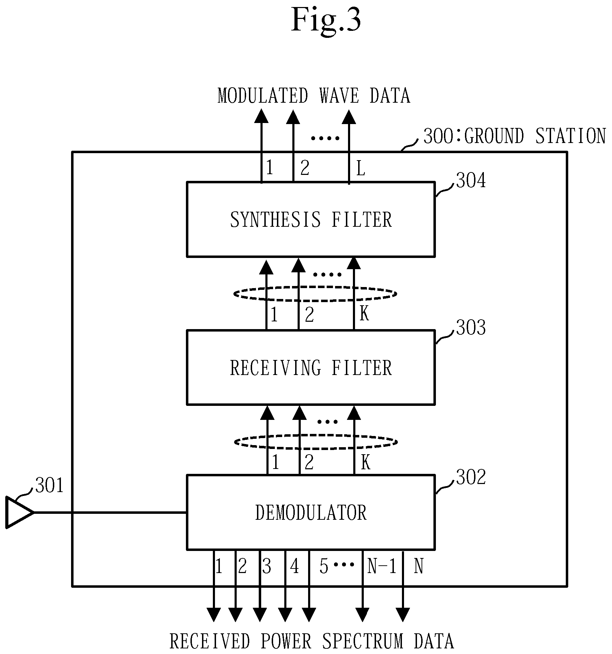

A configuration of the ground station 300 will be described with reference to Fig. 3.

The ground station 300 includes a receiving antenna 301, a demodulator 302, a receiving filter 303, and a synthesis filter 304.

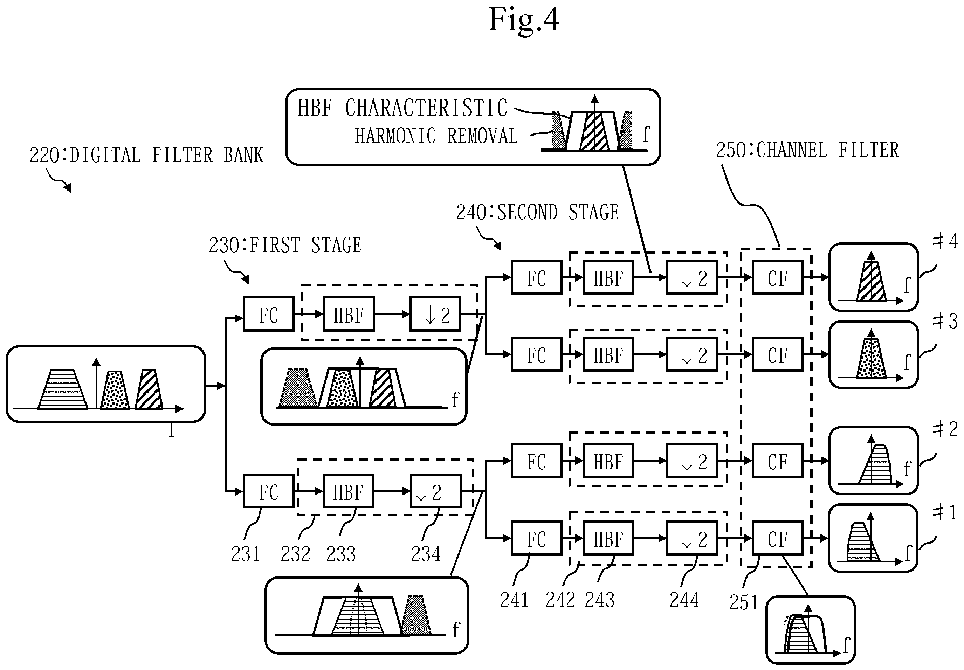

A configuration of the digital filter bank 220 will be described with reference to Fig. 4.

Fig. 4 illustrates an example of the configuration of the digital filter bank 220 when decomposing a baseband signal into four subbands.

The digital filter bank 220 is composed of one or more stages (pre-stages) and a channel filter 250 (final stage).

Each stage is composed of a plurality of frequency converters (FC) and a plurality of decimation-by-2 filters. The decimation-by-2 filter is composed of a half band filter (HBF) and a decimator-by-2 (↓2).

The channel filter 250 is composed of a plurality of channel filters 251.

"FC" is an abbreviation for Frequency Convertor.

"HBF" is an abbreviation for Half Band Filter.

"↓2" represents a decimator-by-2.

"CF" is an abbreviation for Channel Filter.

The digital filter bank 220 decomposes a baseband signal into 1/2, 1/4, 1/8, ... at each stage.

The configuration other than the channel filter 250 is the same as the configuration of the tree circuit described in Patent Literature 3.

The digital filter bank 220 is realized by, for example, a tree circuit illustrated in Fig. 4.

The digital filter bank 220 includes a first stage 230, a second stage 240, and the channel filter 250.

The first stage 230 includes two pairs of frequency converter 231 and decimation-by-2 filter 232. The decimation-by-2 filter 232 is composed of a half band filter 233 and a decimator-by-2 234.

The second stage 240 includes two pairs of frequency converter 241 and decimation-by-2 filter 242 for each of the pairs of frequency converter 231 and decimation-by-2 filter 232. The decimation-by-2 filter 242 is composed of a half band filter 243 and a decimator-by-2 244.

The channel filter 250 includes the channel filter 251 for each of the pairs of frequency converter 241 and decimation-by-2 filter 242.

The digital filter bank 220 decomposes an input baseband signal into four subbands and outputs four pieces of complex subband data (#1 to #4).

The digital filter bank 220 may have a configuration where the number of decomposition N is other than 4.

The number of decomposition N has a relationship "N = 2S" with respect to the number of stages S. Increasing the number of stages S allows the number of decomposition N to be increased.

The digital filter bank 220 decomposes an input baseband signal into N subbands and outputs N pieces of complex subband data (#1 to #N).

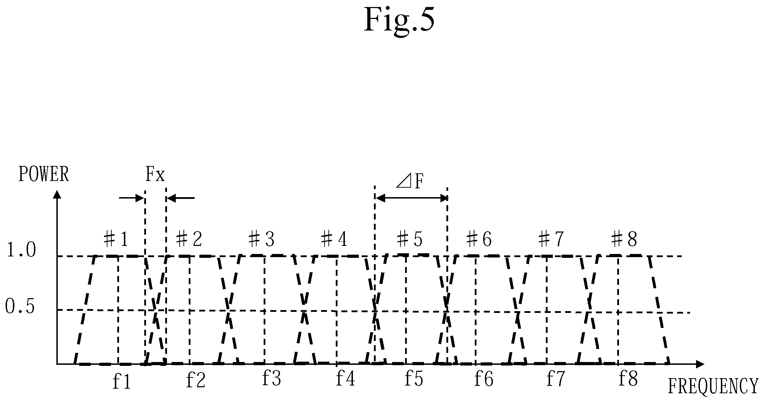

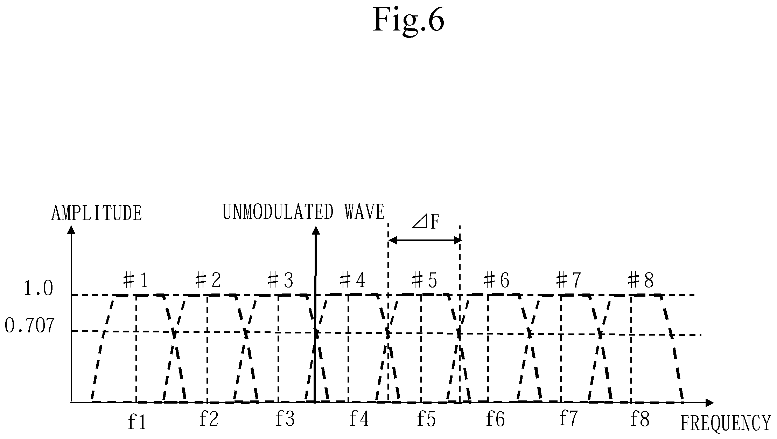

The frequency characteristic of the digital filter bank 220 will be described with reference to Fig. 5 and Fig. 6.

Fig. 5 illustrates a frequency-to-power characteristic of the digital filter bank 220.

A plurality of subbands (#1 to #8) are arranged consecutively in a frequency direction at a frequency spacing ΔF.

At the point where the frequency-to-power characteristics of two subbands adjacent in the frequency direction intersect, the power of each subband is 0.5.

Single-sided transition bandwidth Fx is narrow. The single-sided transition bandwidth Fx is a region where the frequency-to-power characteristics of two adjacent subbands overlap with each other.

The digital filter bank 220 has a frequency characteristic where the power sum of the frequency-to-power characteristics of two subbands adjacent in the frequency direction (= 1.0) is constant.

The frequency characteristic of the digital filter bank 220 is provided to the channel filter 250.

Fig. 6 illustrates a frequency-to-amplitude characteristic of the digital filter bank 220.

At the point where the frequency-to-amplitude characteristics of two adjacent subbands intersect with each other, the amplitude is 0.707. "0.707" corresponds to the square root of 0.5 (1/2).

The unmodulated wave means a received signal. When an unmodulated wave exists at a frequency where the frequency-to-amplitude characteristics of the subband #3 and the subband #4 intersect with each other, the power detected in each of the subband #3 and the subband #4 is 1/2 times. "1/2" is equivalent to the square of 0.707. Accordingly, the sum of respective power detected in the subband #3 and the subband #4 is 1 time. This means that the sum of the detected power equals the received power of the unmodulated wave. Consequently, no error occurs when detecting the power spectrum of the received signal.

Although Figs. 5 and 6 illustrate the case where the baseband signal is decomposed into eight subbands, the number of decomposition N may be any integer as long as the number is equal to or greater than two.

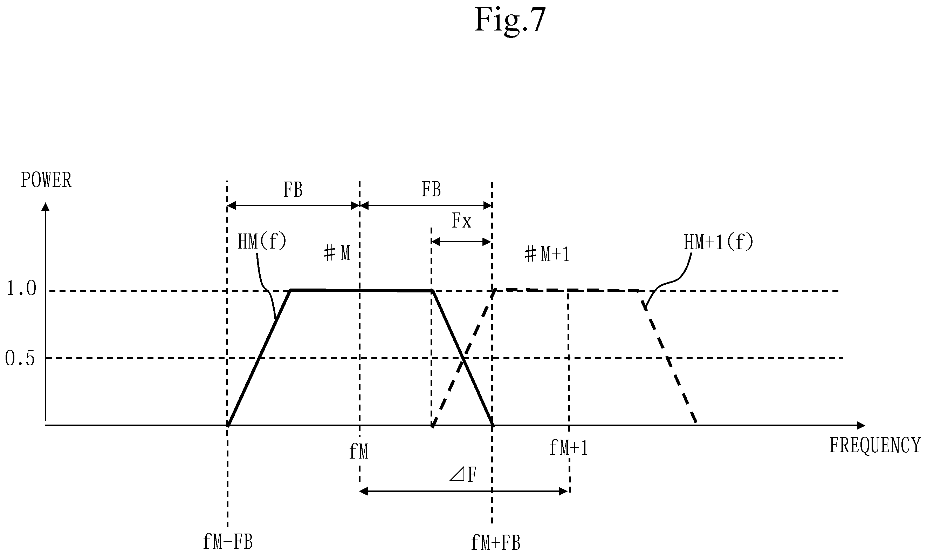

Details of the frequency characteristic of the digital filter bank 220 will be described with reference to Fig. 7.

"#m" represents a subband number.

"fM" represents a center frequency of an unmodulated wave.

"HM(f)" represents a frequency-to-normalized-power characteristic. The normalized power is power expressed by normalizing an unmodulated wave with the power of the center frequency fM.

"ΔF" represents the frequency spacing between two subbands consecutive in the frequency direction.

"Fx" represents bandwidth of a single-sided transition region (single-sided transition bandwidth) in the frequency characteristic. The single-sided transition bandwidth Fx is greater than 0 and equal to or smaller than the frequency spacing ΔF.

"FB" represents bandwidth of a single-sided occupied region (single-sided occupied bandwidth) in the frequency characteristic. The single-sided occupied bandwidth FB includes the single-sided transition bandwidth Fx. The single-sided occupied bandwidth FB is greater than 0 and equal to or smaller than the frequency spacing ΔF.

The digital filter bank 220 has the frequency characteristic where the single-sided occupied bandwidth FB of each subband is equal to or smaller than the frequency spacing ΔF.

The frequency characteristic of the digital filter bank 220 is provided to the channel filter 250.

In the digital filter bank 220, the frequency characteristic of each subband satisfies expression (1).
FORMULA 1 $\left\{\begin{matrix}{H}_{M} \left(f\right) + {H}_{M + 1} \left(f\right) = 1 \left({f}_{M}≦f≦{f}_{M + 1}\right) \\ {H}_{M} \left(f\right) = 0 \left(f<{f}_{M}-{F}_{B}, f>{f}_{M}+{F}_{B}\right)\end{matrix}\right\}$ Expression (1)

By satisfying expression (1), the frequency characteristic is realized where the single-sided occupied bandwidth FB of each subband is equal to or smaller than the frequency spacing ΔF and the power sum of the frequency-to-power characteristics of two subbands adjacent in the frequency direction is constant.

By setting the range of the single-sided transition bandwidth Fx to 0 < Fx ≤ ΔF, the range of the single-sided occupied bandwidth FB becomes 0 < FB ≤ ΔF.

As a result, a double-sided occupied bandwidth of each subband is limited to 2×ΔF or smaller.

The digital filter bank 220 may be any type as long as it has the frequency characteristic which satisfies expression (1).

For example, a root roll-off filter can be used to satisfy expression (1).

When using the root roll-off filter, ΔF may be set as a symbol frequency and Fx/ΔF may be set as a roll-off rate.

The symbol frequency and roll-off rate are parameters of the root roll-off filter.

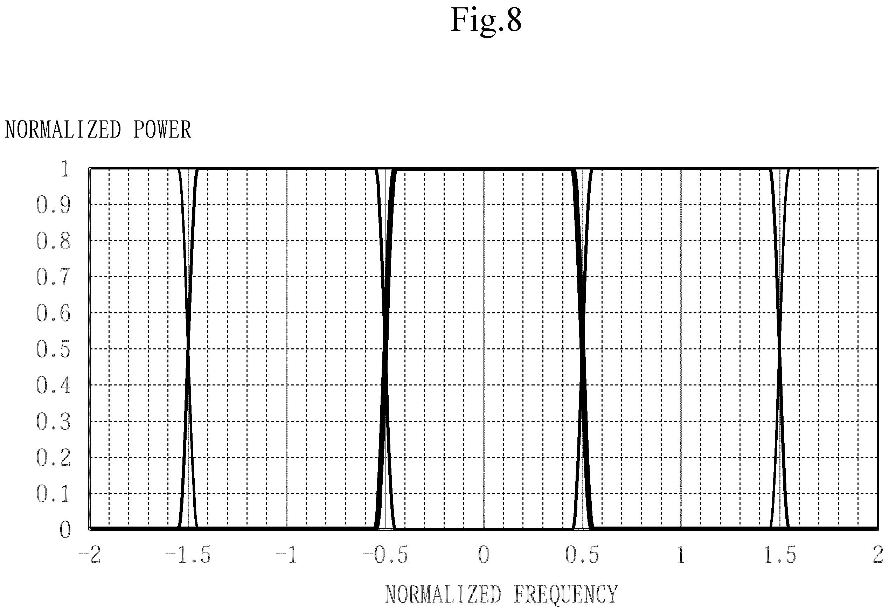

Fig. 8 illustrates the frequency characteristic of the digital filter bank 220 when using the root roll-off filter. The roll-off rate is 0.1.

For example, the frequency characteristic of the root roll-off filter is provided to the channel filter 250.

The channel filter 250 employs the configuration of a FIR filter. Therefore, when a filter coefficient sequence of the channel filter 250 is set to an impulse sequence of the root roll-off filter, the frequency characteristic which satisfies expression (1) is realized.

The frequency characteristic of the receiving filter 303 in the ground station 300 will be described.

The receiving filter 303 has the same frequency characteristic as the frequency characteristic of the digital filter bank 220.

In the receiving filter 303, the frequency characteristic of each subband satisfies expression (1).

The receiving filter 303 is composed of a plurality of channel filters as the channel filter 250, and the same frequency characteristic as the frequency characteristic of the digital filter bank 220 is provided to the receiving filter 303.

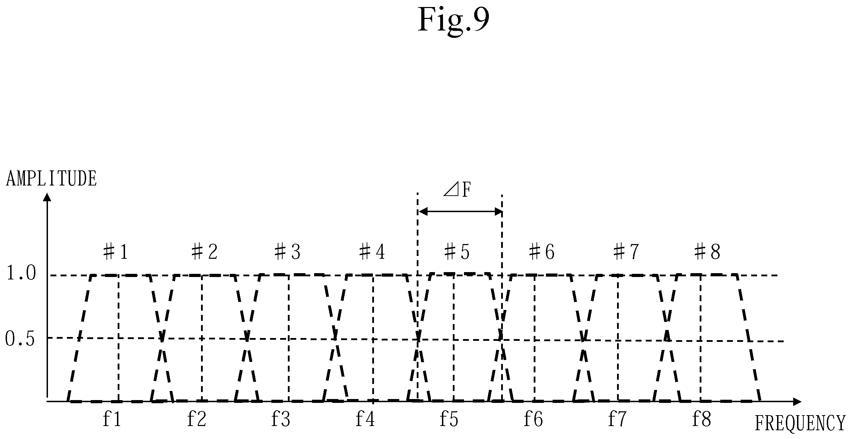

Fig. 9 illustrates a frequency-to-amplitude characteristic after passing through the receiving filter 303.

At the point where the frequency-to-amplitude characteristics of two subbands adjacent in the frequency direction intersect with each other, the amplitude of each subband is 0.5.

The frequency characteristic after passing through the receiving filter 303 exhibits a frequency characteristic where the amplitude sum of the frequency-to-amplitude characteristics of two subbands adjacent in the frequency direction (= 1.0) is constant.

Such a frequency characteristic is exhibited after passing through the receiving filter 303, enabling the synthesis filter 304 on the subsequent stage to perform amplitude vector synthesis (synthesis processing) to restore a normal modulated wave.

### ***Description of operation***

An operation of the terminal station 200 will be described with reference to Fig. 2.

The receiving antenna 201 receives a radio wave in a target observation band. The received radio wave is referred to as a received signal.

The variable attenuator 202 attenuates the received signal in accordance with a command from the automatic gain controller 206.

The bandpass filter 203 limits the band of the received signal. The bandpass filter 203 functions as an anti-aliasing filter to prevent aliasing components from overlapping with the target observation band during AD conversion processing at the subsequent stage.

The AD converter 204 samples the received signal which has passed through the bandpass filter 203 using a clock signal supplied from the oscillator 205.

The oscillator 205 supplies a clock signal to the AD converter 204 and each functional block performing digital signal processing after the AD conversion processing.

The automatic gain controller 206 operates as described below to prevent the input level of the received signal to the AD converter 204 from exceeding the full scale. The automatic gain controller 206 detects a reception level from the received signal which has passed through the AD converter 204. When the detected reception level exceeds a threshold value, the automatic gain controller 206 issues a command to the variable attenuator 202 to apply attenuation.

The downconverter 207 converts the frequency of RF data obtained from sampling by the AD converter 204 and outputs a baseband signal (= I/Q data).

The digital filter bank 220 decomposes the baseband signal output from the downconverter 207 into a plurality of subbands and outputs a plurality of pieces of complex subband data.

An example of the operation of the digital filter bank 220 will be described with reference to Fig. 4.

The first stage 230 decomposes the baseband signal to be halved.

The second stage 240 decomposes the baseband signal, which has been decomposed to be halved, to be one-quarter.

Thus, the baseband signal is decomposed into four subband signals.

The channel filter 250 filters the four subband signals and outputs four pieces of subband data (#1 to #4).

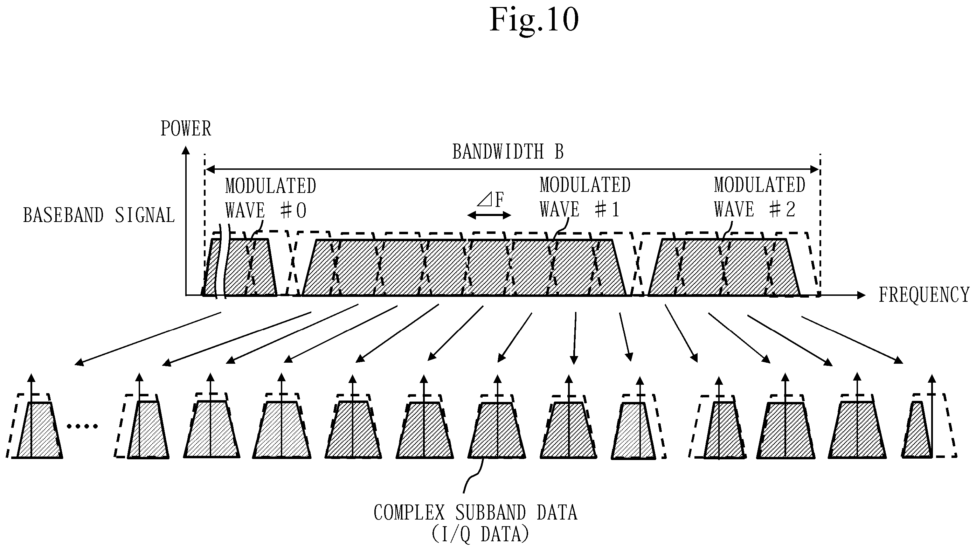

Fig. 10 illustrates an image of decomposition processing by the digital filter bank 220.

Shaded trapezoids represent modulated waves. Dashed trapezoids represent the frequency characteristic of the digital filter bank 220.

The input baseband signal has a bandwidth B and contains three modulated waves (#0 to #2). The bandwidth B has a relationship B = N×ΔF.

The input baseband signal is decomposed into a plurality of pieces of complex subband data at the frequency spacing ΔF.

Referring back to Fig. 2, the description will be continued.

The power converter 208 calculates the received power of a received signal in each subband based on the complex subband data for each subband and outputs received power spectrum data.

The received power spectrum data indicates a received power sequence of a plurality of subbands. That is, the received power spectrum data indicates the received power of a plurality of subbands.

Specifically, the power converter 208 operates as described below.

The power converter 208 squares the N pieces of complex subband data to convert them into power.

At this time, the power converter 208 calculates the received power of each subband by calculating expression (2).

"iT" represents time (i = 1, 2, 3, ...).

"T" represents a sample cycle.

"#M" represents a subband number (M = 1, 2, 3, ..., N).

"P_{M}(i)" represents received power of subband #M at time i.

"I_{M}(i)" represents power of I data of subband #M at time i.

"Q_{M}(i)" represents power of Q data of subband #M at time i.
FORMULA 2 ${P}_{M} \left(i\right) = {I}_{M} {\left(i\right)}^{2} + {Q}_{M} {\left(i\right)}^{2}$ Expression (2)

By calculating expression (2) for each time iT, the received power sequence P₁(i) to P_{N}(i) is obtained.

The frequency spacing of the subbands is ΔF. Therefore, the received power sequence corresponds to the received power spectrum at time iT, its frequency resolution corresponds to the frequency spacing ΔF, and the number of decomposition N corresponds to the number of points.

A frequency span is a bandwidth B of an input baseband signal.

The bandwidth B has a relationship B = N×ΔF (see Fig. 10). Therefore, when the bandwidth B is constant, increasing the number of decomposition N results in a finer frequency resolution corresponding to the frequency spacing ΔF as a reciprocal of the number of decomposition N.

Here, in Fig. 2, when the automatic gain controller 206 applies an attenuation amount L [decibels] to the variable attenuator 202, the received power received by the receiving antenna 201 is higher by L [decibels] than the received power spectrum calculated by expression (2). Therefore, to obtain the received power spectrum received by the receiving antenna 201, the received power spectrum obtained from expression (2) is multiplied by L [decibels].

Operations of the modulator 209 and the transmitting antenna 210 will be described.

The modulator 209 modulates the received power spectrum data and outputs a radio signal. Further, the modulator 209 modulates two or more pieces of complex subband data which are arranged consecutively in the frequency direction from among the plurality of pieces of complex subband data and outputs a radio signal.

The transmitting antenna 210 transmits the radio signal of the received power spectrum data to the ground station 300. Further, the transmitting antenna 210 transmits the radio signal of the two or more pieces of complex subband data to the ground station 300.

An operation of the ground station 300 will be described with reference to Fig. 3.

The receiving antenna 301 receives the radio signal of the received power spectrum data. Further, the receiving antenna 301 receives the radio signal of the two or more pieces of complex subband data.

The demodulator 302 demodulates the received radio signal to obtain the received power spectrum data. Further, the demodulator 302 demodulates the received radio signal to obtain the two or more pieces of complex subband data.

The receiving filter 303 filters the two or more pieces of complex subband data.

The synthesis filter 304 synthesizes the two or more pieces of complex subband data after filtering so as to restore modulated wave data of each of one or more modulated waves contained in the two or more pieces of complex subband data from among one or more modulated waves contained in the baseband signal.

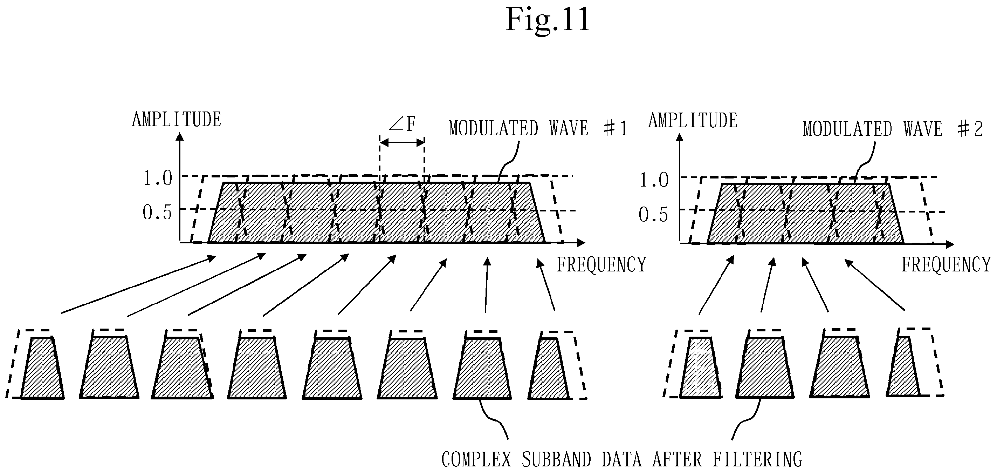

Fig. 11 illustrates an image of synthesis processing by the synthesis filter 304.

Shaded trapezoids represent modulated waves. Dashed trapezoids represent the frequency characteristic obtained after passing through the receiving filter 303.

The synthesis filter 304 synthesizes K pieces of complex subband data to restore L pieces of modulated data (1 ≤ L < K).

In Fig. 11, two modulated waves (#1, #2) are decomposed into 12 subbands. Each of 12 pieces of complex subband data is filtered by the receiving filter 303. The synthesis filter 304 synthesizes eight pieces of complex subband data, which are consecutive on the frequency axis, to restore the modulated wave #1. At the same time, the synthesis filter 304 synthesizes four pieces of complex subband data, which are consecutive on the frequency axis, to restore the modulated wave #2.

### ***Advantageous effects of Embodiment 1***

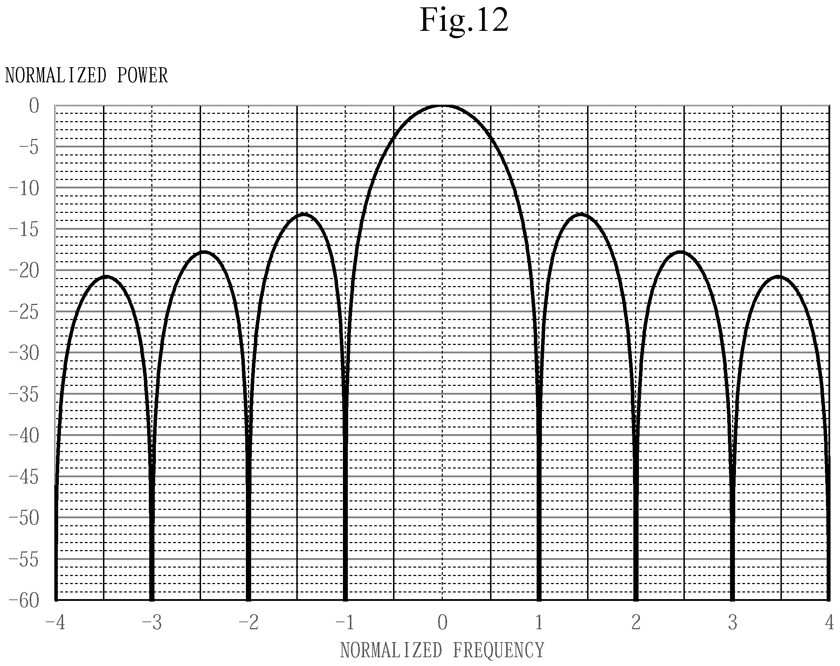

Fig. 12 illustrates an example of a conventional normalized-frequency-to-power characteristic. A normalized frequency is a frequency normalized by a bandwidth of a subband (bin).

When using a rectangular window to extract a time waveform during the FFT in power spectrum detection using the FFT, a frequency characteristic of a subband corresponding to each bin is as shown in Fig. 12.

This frequency characteristic is a SINC characteristic which is not limited to its own subband (normalized frequency: -0.5 to +0.5) but extends to a plurality of subbands (bins).

Therefore, even when an adjacent subband signal is input, its leakage power is detected in the own subband and as a result, the received power spectrum is observed to be broadened.

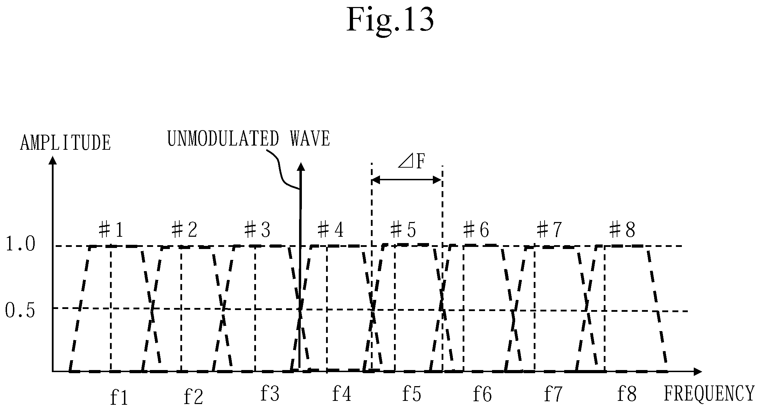

Fig. 13 illustrates an example of a conventional frequency-to-amplitude characteristic.

When the amplitude at an intersection point of frequency characteristics of two adjacent subbands is 0.5 (= 1/2), the detection result exhibits an error of up to -3 decibels.

When an unmodulated wave exists at a frequency where the frequency characteristics of the subband #3 and the subband #4 intersect with each other, the power detected in each of the subband #3 and the subband #4 is one-quarter. One-quarter the received power corresponds to a square of one-half the amplitude.

Accordingly, the sum of respective power detected in the subband #3 and the subband #4 is 1/2 (= 1/4+1/4).

This means that the sum of the detected power is one-half the received power of the unmodulated wave.

That is, when detecting the power spectrum of the received signal, an error of -3 decibels occurs in the detection result.

Embodiment 1 has been made in light of the above-mentioned problems.

In Embodiment 1, the digital filter bank 220 is used in which the power sum of the frequency characteristics of two adjacent subbands is 1. This makes it possible to accurately detect the received power spectrum while ensuring the amount of suppression outside the subband in the same manner as in the method of Patent Literature 3.

By employing the digital filter bank 220, it is possible to achieve accurate received power spectrum detection without errors, regardless of the frequency of the received signal.

In the terminal station 200, a frequency characteristic is provided to the digital filter bank 220 which decomposes a baseband signal into a plurality of subbands, such that the power sum of frequency characteristics of two adjacent subbands is 1. Further, the single-sided occupied bandwidth of each subband is kept within the frequency spacing ΔF between the subbands. This makes it possible to obtain accurate received power spectrum information.

Also, in the ground station 300 which receives and analyzes the K pieces of complex subband data obtained through the decomposition by the digital filter bank 220, the same frequency characteristic as that provided to the digital filter bank 220 is provided to the receiving filter 303. This makes it possible to synthesize the K pieces of complex subband data filtered by the receiving filter 303 to obtain a correctly restored modulated wave. Accordingly, accurate analysis of modulated waves can be realized.

### ***Supplementary description for Embodiment 1***

In the terminal station 200, if the condition that the input level of the AD converter 204 does not exceed full scale is satisfied, the automatic gain controller 206 and the variable attenuator 202 are not necessary.

When the bandwidth of a desired received spectrum is less than one-fourth the sampling rate of the AD converter 204, the downconverter 207 may output data after reducing the sampling rate using a decimation filter.

The synthesis filter 304 can be realized by, for example, the tree circuit described in Patent Literature 3.

Embodiment 1 is based on the premise that a center frequency and bandwidth of each modulated wave are known. In processing for selecting K pieces of complex subband data from M pieces of complex subband data and processing for restoring L pieces of modulated wave data from the K pieces of complex subband data, allocation of each piece of complex subband data is performed based on known information.

However, the center frequency and bandwidth of each modulated wave may be unknown in Embodiment 1. For example, the terminal station 200 compares received power spectra P₁(i) to P_{N}(i) with a threshold value TH. Then, the terminal station 200 transmits the complex subband data of each subband, whose received power spectrum P exceeds the threshold value TH, together with the subband number #M, to the ground station 300. This allows the ground station 300 to restore L pieces of modulated wave data in the same manner as when the center frequency and bandwidth of each modulated wave are known.

### Embodiment 2.

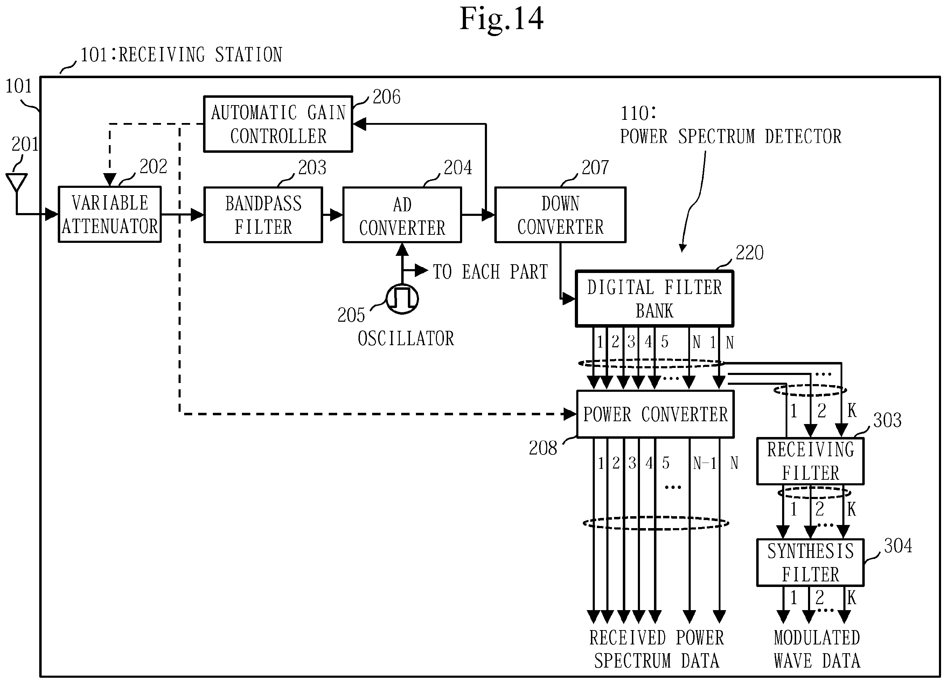

Regarding a receiving station 101 corresponding to the receiving system 100, points differing from Embodiment 1 will be mainly described with reference to Fig. 14.

### ***Description of configuration***

A configuration of the receiving station 101 will be described with reference to Fig. 14.

The receiving station 101 includes the receiving antenna 201, the variable attenuator 202, the bandpass filter 203, the AD converter 204, the oscillator 205, the automatic gain controller 206, the downconverter 207, the digital filter bank 220, and the power converter 208.

The receiving station 101 further includes the receiving filter 303 and the synthesis filter 304.

The receiving station 101 includes the power spectrum detector 110.

The power spectrum detector 110 is the circuit which includes the digital filter bank 220 and the power converter 208.

### ***Description of operation***

An operation of the receiving station 101 will be described with reference to Fig. 14.

The receiving antenna 201 receives a radio wave in a target observation band.

The variable attenuator 202 attenuates the received signal in accordance with a command from the automatic gain controller 206.

The bandpass filter 203 limits the band of the received signal.

The AD converter 204 samples the received signal which has passed through the bandpass filter 203 using a clock signal supplied from the oscillator 205.

The downconverter 207 converts the frequency of RF data obtained from sampling by the AD converter 204 and outputs a signal of baseband data (= I/Q data).

The digital filter bank 220 decomposes the baseband signal output from the downconverter 207 into a plurality of subbands and outputs a plurality of pieces of complex subband data.

The power converter 208 calculates the received power of a received signal in each subband based on the complex subband data for each subband and outputs received power spectrum data.

The receiving filter 303 filters two or more pieces of complex subband data which are arranged consecutively in the frequency direction from among the plurality of pieces of complex subband data.

The synthesis filter 304 synthesizes the two or more pieces of complex subband data after filtering so as to restore the modulated wave data of each of one or more modulated waves contained in the two or more pieces of complex subband data from among one or more modulated waves contained in the baseband signal.

### ***Advantageous effect of Embodiment 2***

When there is no need to transmit the received power spectrum data and the complex subband data wirelessly, the receiving station 101 replaces the receiving system 100.

By employing the receiving station 101 instead of the receiving system 100, the hardware scale can be reduced.

### ***Supplementary description for Embodiment 2***

The receiving system 100 may include a master station and a plurality of receiving stations 101. Any one of the receiving stations 101 may function as the master station. The master station and each receiving station 101 are connected by wire.

Each receiving station 101 is placed outdoors or indoors.

The master station collects received power spectrum data and complex subband data from each receiving station 101, and monitors or analyzes the received power spectrum data and the complex subband data.

### Embodiment 3.

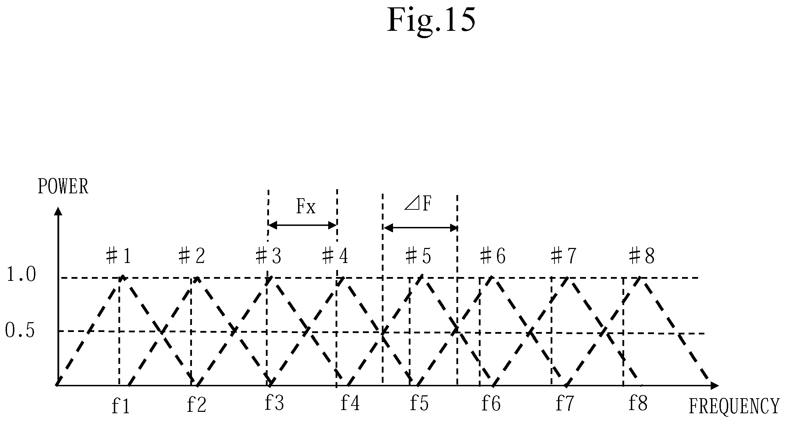

Regarding the mode of estimating the center frequency of a received signal, points differing from Embodiment 1 and Embodiment 2 will be mainly described with reference to Figs. 15 to 18.

### ***Description of configuration***

The configuration of the receiving system 100 is the same as the configuration in Embodiment 1.

The configuration of the receiving station 101 is the same as the configuration in Embodiment 2.

However, the power converter 208 is assumed to further have the function of a frequency estimator.

The frequency estimator estimates a center frequency of a received signal based on a relationship between magnitudes of power in frequency-to-power characteristics of two subbands adjacent in the frequency direction, and outputs the value of the estimated center frequency.

The frequency characteristic of the digital filter bank 220 will be described.

The frequency characteristic of the digital filter bank 220 further has a constraint that the single-sided transition bandwidth Fx is equal to the frequency spacing ΔF (Fx = ΔF).

Fig. 15 illustrates an example of a frequency-to-power characteristic of the digital filter bank 220.

In the graph of the frequency-to-power characteristic, when the frequency characteristic of each subband forms a triangle, the frequency-to-power characteristic corresponds to the frequency characteristic of the digital filter bank 220.

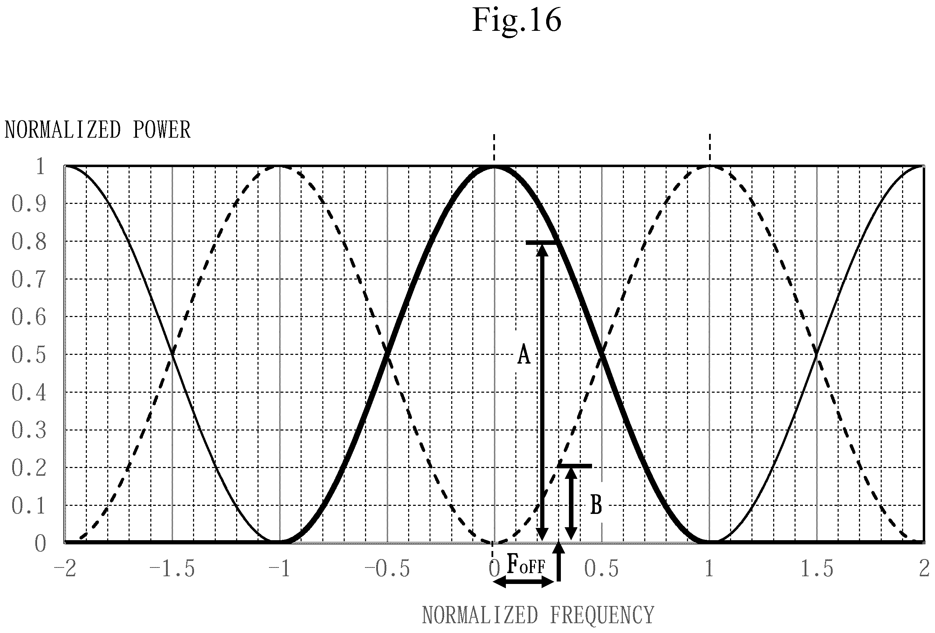

Fig. 16 illustrates the frequency characteristic of the digital filter bank 220 when using the root roll-off filter. The roll-off rate is 1.0.

The solid waveform represents the frequency characteristic of the own channel. The dotted waveform represents a frequency characteristic of an adjacent channel.

It is assumed that an unmodulated signal with a normalized power of 1 is received at a normalized frequency indicated by an up arrow (↑).

In this case, normalized power A of the subband of the own channel and normalized power B of the subband of the adjacent channel are detected in the received power spectrum. The adjacent channel is the channel immediately next to the own channel.

In this case, the sum of the normalized power A and the normalized power B is 1.

Even if a received signal appears at the subband boundary, the accuracy of the received power measurement is maintained without power loss.

Furthermore, the center frequency of the unmodulated signal can be estimated based on the relationship between the normalized power A and the normalized power B.

### ***Description of operation***

The power converter 208 detects the normalized power A of the subband of the own channel and the normalized power B of the subband of the adjacent channel and estimates the center frequency of the received signal based on the relationship between the normalized power A and the normalized power B.

The center frequency of the received signal is estimated as described below.

First, the power converter 208 calculates the arctangent of the normalized power B relative to the normalized power A (ATAN(B/A)).

Next, the power converter 208 obtains the offset frequency corresponding to the value of the calculated arctangent from a lookup table.

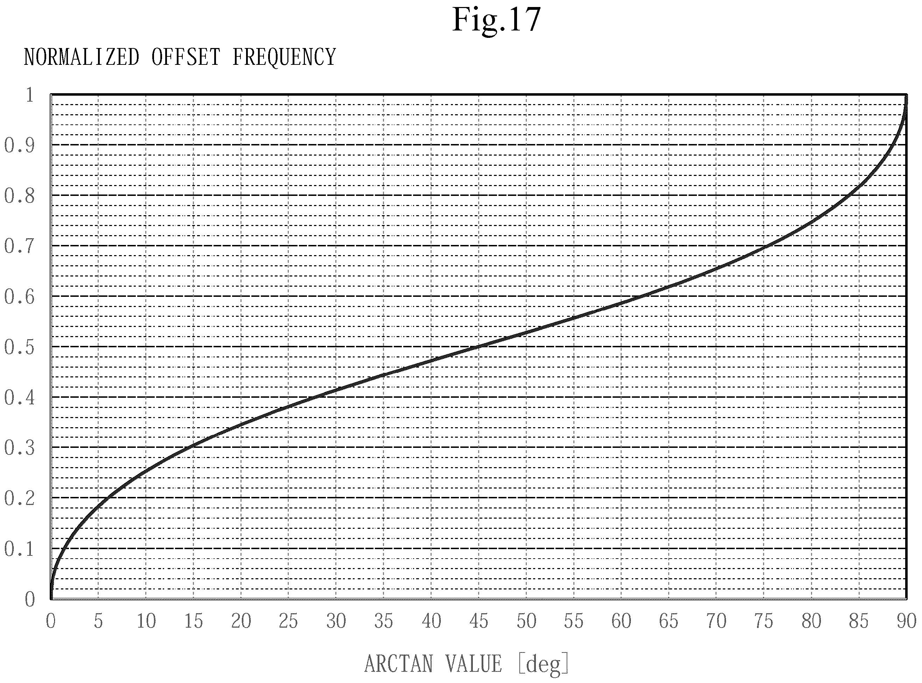

Fig. 17 illustrates an example of the lookup table. The lookup table is data showing a relationship between arctangent values and (normalized) offset frequencies.

The power converter 208 then calculates the center frequency Fc of the received signal using the obtained offset frequency F_{OFF}, the center frequency f_{M} of its own channel, and the frequency spacing ΔF.

The center frequency Fc of the received signal is expressed by the following expression. $Fc = {f}_{M} + \left({F}_{OFF}\right) \times ΔF$

### ***Advantageous effects of Embodiment 3***

In Embodiment 3, the additional constraint (Fx = ΔF) is applied to the subband frequency characteristic provided to the digital filter bank 220.

This makes it possible to estimate the center frequency of a received signal with an accuracy smaller than the frequency resolution ΔF.

Conventionally, it has not been possible to estimate the center frequency of a received signal with fine accuracy unless the frequency resolution is increased by increasing the number of decomposition N. The resolution corresponds to the subband bandwidth.

In Embodiment 3, the center frequency of a received signal can be estimated with fine accuracy smaller than the frequency resolution of the received spectrum. In other words, in Embodiment 3, the center frequency of a received signal can be estimated with fine accuracy even when the number of decomposition N is small (even when the frequency resolution is coarse).

Furthermore, suppressing the increase in the number of decomposition N leads to the reduction in the circuit scale of the digital filter bank 220.

In other words, Embodiment 3 makes it possible to estimate the center frequency of a received signal with high accuracy while keeping the hardware scale down.

### ***Supplementary description for Embodiment 3***

Embodiment 3 may be applied to estimate the center frequency of a received signal other than unmodulated waves. Embodiment 3 is applicable to signals having a bandwidth (band-limited signals).

When a band-limited signal is received, the received power is not necessarily detected only in two adjacent subbands, but may be detected in three or more consecutive subbands along the frequency axis. In this case as well, the center frequency of the band-limited signal can be estimated based on the relationship among the received powers P_{M}(i) to P_{M+J-1}(i) detected in respective subbands. Here, "J" is an integer of 3 or greater.

For example, the power converter 208 calculates a moving average of the received powers P_{M}(i) to P_{M+J-1}(i) detected in respective subbands, and calculates the frequency which indicates a peak point of an average power characteristic after the moving averaging. The calculated frequency is the center frequency of the band-limited signal.

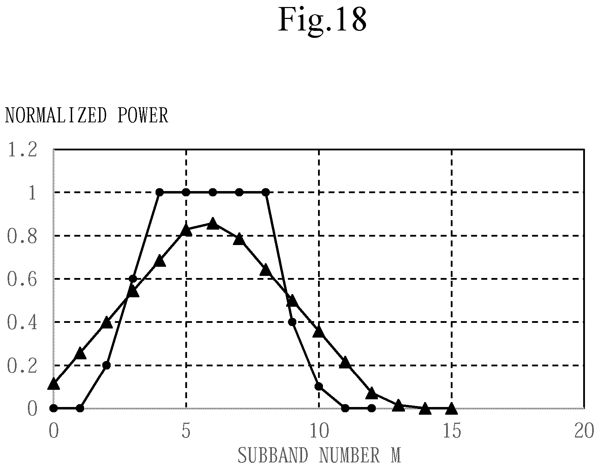

Fig. 18 illustrates an example of the moving average of the band-limited signal.

The waveform obtained by connecting circles represents a power spectrum of a band-limited signal. The band-limited signal has a bandwidth of approximately 5 subbands.

The waveform obtained by connecting triangles represents a power spectrum after moving averaging.

When applying the moving averaging over a bandwidth slightly wider than the bandwidth of the band-limited signal (7 subbands), the power spectrum after the moving averaging has a peak at the subband (M = 6) which is nearly the center frequency of the band-limited signal.

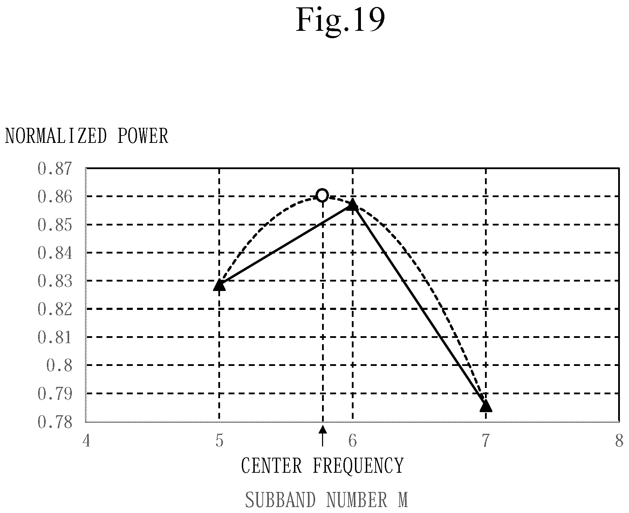

An example of center frequency estimation will be described with reference to Fig. 19.

The power converter 208 calculates an approximation curve (dashed curve) which connects a peak value of a subband having a peak with values before and after the peak.

The power converter 208 then calculates a frequency corresponding to the peak of the approximation curve. The calculated frequency is the center frequency of the band-limited signal.

The processing for estimating the center frequency of the received signal (frequency estimation processing) may be performed anywhere after the received power spectrum is obtained.

For example, the frequency estimation processing is performed at the terminal station 200, the ground station 300, or the receiving station 101. When the frequency estimation processing is performed at the terminal station 200, the estimated center frequency is transmitted wirelessly to the ground station 300 along with the received power spectrum.

### Embodiment 4.

Regarding the mode of switching the single-sided transition band Fx, points differing from Embodiment 3 will be mainly described.

### ***Description of configuration***

The configuration of the receiving system 100 is the same as the configuration in Embodiment 1.

The configuration of the receiving station 101 is the same as the configuration in Embodiment 2.

When the center frequency of a received signal is estimated, the digital filter bank 220 operates with the frequency characteristic in which the single-sided transition bandwidth Fx is equal to the frequency spacing ΔF.

When the received power of the received signal is calculated for each subband, the digital filter bank 220 operates with the frequency characteristic in which the single-sided transition bandwidth Fx is smaller than the frequency spacing ΔF.

### ***Description of operation***

The digital filter bank 220 switches the single-sided transition band Fx within the range 0 < Fx ≤ ΔF. When a root roll-off filter is used, the digital filter bank 220 switches the roll-off rate R within the range 0 < R ≤ 1.

For example, when estimating the center frequency of a received signal as in Embodiment 3, the digital filter bank 220 sets the single-sided transition bandwidth Fx to be equal to the frequency spacing ΔF. This widens the bandwidth of each subband.

For example, when observing the signal power of each subband as in Embodiment 1, the digital filter bank 220 sets the single-sided transition bandwidth Fx to be smaller than the frequency spacing ΔF (for example, Fx = 0.1ΔF). This narrows the bandwidth of each subband. Also, when transmitting a plurality of pieces of complex subband data from the terminal station 200 to the ground station 300, the digital filter bank 220 sets the single-sided transition bandwidth Fx to be smaller than the frequency spacing ΔF. This narrows the bandwidth of each subband. Narrowing the subband bandwidth reduces a sampling rate. Consequently, an advantageous effect is obtained in which the transmission rate of the complex subband data from the terminal station 200 to the ground station 300 can be reduced.

### ***Advantageous effects of Embodiment 4***

According to Embodiment 4, it is possible to realize the receiving system 100 or the receiving station 101 which can flexibly accommodate various purposes or applications.

### ***Supplementary description for embodiments***

The embodiments relate to the terminal station 200 and the receiving station 101, both of which have the function of detecting the power spectrum of received signals.

Examples of applications for the terminal station 200 include artificial satellites and unmanned aerial vehicles.

Examples of applications for the receiving station 101 include sensors placed on the ground.

Each embodiment is an example of a preferred embodiment and is not intended to limit the technical scope of the present disclosure. Each of the embodiments may be implemented in part or in combination with other embodiments.

Various aspects of the present disclosure are described below as appendices.

### (Appendix 1)

A power spectrum detector including:
a digital filter bank to decompose a baseband signal obtained from a received signal into a plurality of subbands and to output a plurality of pieces of complex subband data; and
a power converter to calculate, for each subband of the plurality of subbands, received power of the received signal in the subband based on said complex subband data for the subband and to output received power spectrum data, in which
the plurality of subbands are arranged consecutively in a frequency direction at a frequency spacing ΔF, and
the digital filter bank has a frequency characteristic where a single-sided occupied bandwidth of each subband of the plurality of subbands is equal to or smaller than the frequency spacing ΔF and a power sum of frequency-to-power characteristics of two subbands adjacent in the frequency direction among the plurality of subbands is constant.

### (Appendix 2)

The power spectrum detector according to appendix 1, in which
the digital filter bank sets a single-sided transition bandwidth of each subband of the plurality of subbands to be equal to the frequency spacing ΔF, and
the power converter estimates a center frequency of the received signal based on a relationship between magnitudes of power in the frequency-to-power characteristics of the two subbands adjacent in the frequency direction, and outputs a value of the center frequency estimated and the received power spectrum data.

### (Appendix 3)

The power spectrum detector according to appendix 2, in which
the digital filter bank
operates with a frequency characteristic where the single-sided transition bandwidth is equal to the frequency spacing ΔF when the center frequency of the received signal is estimated, and
operates with a frequency characteristic where the single-sided transition bandwidth is smaller than the frequency spacing ΔF when the received power of the received signal is calculated for each subband.

### (Appendix 4)

The power spectrum detector according to any one of appendices 1 to 3, in which
a root roll-off filter is used in the digital filter bank, and
the frequency characteristic of the digital filter bank is realized by setting a parameter of the root roll-off filter.

### (Appendix 5)

The power spectrum detector according to any one of appendices 1 to 4, in which
the digital filter bank is composed of a tree circuit, the tree circuit including a plurality of frequency converters and a plurality of decimation-by-2 filters and a plurality of channel filters,
the frequency characteristic of the digital filter bank is provided to the plurality of channel filters, and
the plurality of channel filters are arranged on a final stage of the tree circuit, and filter a plurality of subband signals, the plurality of subband signals being obtained by decomposing the baseband signal into the plurality of subbands by the plurality of frequency converters and the plurality of decimation-by-2 filters, so as to output the plurality of pieces of complex subband data.

### (Appendix 6)

A receiving system including:
a terminal station including the power spectrum detector according to any one of appendices 1 to 5; and
a ground station to receive a radio signal, the radio signal being obtained by modulating the received power spectrum data, from the terminal station and to demodulate the radio signal, being received, so as to obtain the received power spectrum data.

### (Appendix 7)

The receiving system according to appendix 6, in which
the terminal station includes
   a modulator to modulate the received power spectrum data and two or more pieces of complex subband data, the two or more pieces of complex subband data being arranged consecutively in the frequency direction, from among the plurality of pieces of complex subband data, and
   a transmitting antenna to transmit the radio signal,
the ground station includes
   a receiving antenna to receive the radio signal,
   a demodulator to demodulate the radio signal so as to obtain the received power spectrum data and the two or more pieces of complex subband data,
   a receiving filter to filter the two or more pieces of complex subband data, and
   a synthesis filter to synthesize the two or more pieces of complex subband data after filtering so as to restore modulated wave data of each of one or more modulated waves contained in the two or more pieces of complex subband data from among one or more modulated waves contained in the baseband signal, and
   the receiving filter has a same frequency characteristic as the frequency characteristic of the digital filter bank.

### (Appendix 8)

A receiving station including:
the power spectrum detector according to any one of appendices 1 to 5;
a receiving filter to filter two or more pieces of complex subband data, the two or more pieces of complex subband data being arranged consecutively in the frequency direction, from among the plurality of pieces of complex subband data; and
a synthesis filter to synthesize the two or more pieces of complex subband data after filtering so as to restore modulated wave data of each of one or more modulated waves contained in the two or more pieces of complex subband data from among one or more modulated waves contained in the baseband signal, in which
the receiving filter has a same frequency characteristic as the frequency characteristic of the digital filter bank.

### Reference Signs List

100: receiving system; 101: receiving station; 110: power spectrum detector; 200: terminal station; 201: receiving antenna; 202: variable attenuator; 203: bandpass filter; 204: AD converter; 205: oscillator; 206: automatic gain controller; 207: downconverter; 208: power converter; 209: modulator; 210: transmitting antenna; 220: digital filter bank; 230: first stage; 231: frequency converter; 232: decimation-by-2 filter; 233: half band filter; 234: decimator-by-2; 240: second stage; 241: frequency converter; 242: decimation-by-2 filter; 243: half band filter; 244: decimator-by-2; 250: channel filter; 251: channel filter; 300: ground station; 301: receiving antenna; 302: demodulator; 303: receiving filter; 304: synthesis filter

## Claims

1. A power spectrum detector comprising:
a digital filter bank to decompose a baseband signal obtained from a received signal into a plurality of subbands and to output a plurality of pieces of complex subband data; and
a power converter to calculate, for each subband of the plurality of subbands, received power of the received signal in the subband based on said complex subband data for the subband and to output received power spectrum data, wherein
the plurality of subbands are arranged consecutively in a frequency direction at a frequency spacing ΔF, and
the digital filter bank has a frequency characteristic where a single-sided occupied bandwidth of each subband of the plurality of subbands is equal to or smaller than the frequency spacing ΔF and a power sum of frequency-to-power characteristics of two subbands adjacent in the frequency direction among the plurality of subbands is constant.

2. The power spectrum detector according to claim 1, wherein
the digital filter bank sets a single-sided transition bandwidth of each subband of the plurality of subbands to be equal to the frequency spacing ΔF, and
the power converter estimates a center frequency of the received signal based on a relationship between magnitudes of power in the frequency-to-power characteristics of the two subbands adjacent in the frequency direction, and outputs a value of the center frequency estimated and the received power spectrum data.

3. The power spectrum detector according to claim 2, wherein
the digital filter bank
operates with a frequency characteristic where the single-sided transition bandwidth is equal to the frequency spacing ΔF when the center frequency of the received signal is estimated, and
operates with a frequency characteristic where the single-sided transition bandwidth is smaller than the frequency spacing ΔF when the received power of the received signal is calculated for each subband.

4. The power spectrum detector according to any one of claims 1 to 3, wherein
a root roll-off filter is used in the digital filter bank, and
the frequency characteristic of the digital filter bank is realized by setting a parameter of the root roll-off filter.

5. The power spectrum detector according to any one of claims 1 to 4, wherein
the digital filter bank is composed of a tree circuit, the tree circuit including a plurality of frequency converters and a plurality of decimation-by-2 filters and a plurality of channel filters,
the frequency characteristic of the digital filter bank is provided to the plurality of channel filters, and
the plurality of channel filters are arranged on a final stage of the tree circuit, and filter a plurality of subband signals, the plurality of subband signals being obtained by decomposing the baseband signal into the plurality of subbands by the plurality of frequency converters and the plurality of decimation-by-2 filters, so as to output the plurality of pieces of complex subband data.

6. A receiving system comprising:
a terminal station including the power spectrum detector according to any one of claims 1 to 5; and
a ground station to receive a radio signal, the radio signal being obtained by modulating the received power spectrum data, from the terminal station and to demodulate the radio signal, being received, so as to obtain the received power spectrum data.

7. The receiving system according to claim 6, wherein
the terminal station includes
a modulator to modulate the received power spectrum data and two or more pieces of complex subband data, the two or more pieces of complex subband data being arranged consecutively in the frequency direction, from among the plurality of pieces of complex subband data, and
a transmitting antenna to transmit the radio signal,
the ground station includes
a receiving antenna to receive the radio signal,
a demodulator to demodulate the radio signal so as to obtain the received power spectrum data and the two or more pieces of complex subband data,
a receiving filter to filter the two or more pieces of complex subband data, and
a synthesis filter to synthesize the two or more pieces of complex subband data after filtering so as to restore modulated wave data of each of one or more modulated waves contained in the two or more pieces of complex subband data from among one or more modulated waves contained in the baseband signal, and
the receiving filter has a same frequency characteristic as the frequency characteristic of the digital filter bank.

8. A receiving station comprising:
the power spectrum detector according to any one of claims 1 to 5;
a receiving filter to filter two or more pieces of complex subband data, the two or more pieces of complex subband data being arranged consecutively in the frequency direction, from among the plurality of pieces of complex subband data; and
a synthesis filter to synthesize the two or more pieces of complex subband data after filtering so as to restore modulated wave data of each of one or more modulated waves contained in the two or more pieces of complex subband data from among one or more modulated waves contained in the baseband signal, wherein
the receiving filter has a same frequency characteristic as the frequency characteristic of the digital filter bank.
